# EUROPÄISCHE PATENTSCHRIFT

(11) **EP 1 883 515 B1**
(45) Veröffentlichungstag und Bekanntmachung des Hinweises auf die Patenterteilung: **29.08.2012**
(21) Anmeldenummer: 06742973.8
(22) Anmeldetag: 18.05.2006
(51) Int. Cl.: B28D 5/00, B65H 3/06, H01L 21/00, B65G 59/06

(54) **EINRICHTUNG ZUM VEREINZELN VON SUBSTRATEN VOM STAPEL**
DEVICE FOR THE SEPARATION OF SUBSTRATES FROM A STACK
DISPOSITIF SERVANT A SEPARER DES SUBSTRATS D'UNE PILE

(30) Priorität: 21.05.2005 DE 102005023618
(43) Veröffentlichungstag der Anmeldung: 06.02.2008
(73) Patentinhaber: ACI ecoTec GmbH, 78658 Zimmern ob Rottweil (DE)
(72) Erfinder: SCHMUTZ, Wolfgang, 78658 Zimmern (DE); KIENINGER, Michael, 69469 Weinheim (DE); JÄGER, Felix, 78333 Stockach (DE)
(74) Vertreter: Dreiss
(86) Internationale Anmeldenummer: PCT/EP2006/004699
(87) Internationale Veröffentlichungsnummer: WO 2006/125559

(56) Entgegenhaltungen:
- EP-A- 0 414 157
- EP-A- 0 762 483
- DE-A1- 2 442 542
- DE-A1- 19 904 834
- US-A1- 2005 056 991

## Beschreibung

Die vorliegende Erfindung bezieht sich auf eine Einrichtung zum Vereinzeln von feuchten Silizium-Wafern von einem Wafer-Stapel nach dem Oberbegriff des Anspruchs 1. Eine solche Einrichtung ist aus der EP 0414157 A2 bekannt.

Wafer aus Silizium zur Herstellung von fotovoltaischen Zellen werden, wie auch in der Mikroelektronik, mit Hilfe von Drahtsägen aus dem Block herausgeschnitten. Dieser Block wurde zuvor mit einer Glasplatte verklebt, um den notwendigen Halt für eine vollständige Durchtrennung zu erzielen. Die einzelnen Zellen hängen dann nur noch an der Klebenaht, da die Drahtsäge auch in den Glasgrund eindringt. Der Sägevorgang erfolgt unter ständiger Spülung mit einem besonderen Medium, das sich mit den Sägekörnern vermischt. Durch dieses pastöse Gemisch haften die Wafer büschelweise fest aufeinander und lassen sich zur weiteren Verarbeitung nur sehr schwer voneinander trennen. Erschwerend kommt hinzu, dass die Wafer bis zum Verarbeitungsprozess ständig feucht gehalten werden müssen. In bekannter Weise werden bisher die Wafer büschelweise von Hand von der Klebenaht abgetrennt und durch Abziehen des obersten Wafers zwischen Daumen und Mittelfinger vereinzelt. Die inzwischen eingetretene Massenfertigung bei der Herstellung von fotovoltaischen Zellen fordert jedoch ein automatisiertes Verfahren. Hinzu kommt, dass die Waferformate immer größer werden. Zur Zeit ist man bei einer Wafergröße von 156 x 156 mm angelangt und der Trend geht zu 210 x 210 mm. Spätestens dann ist man aus ergonomischen Gründen nicht mehr in der Lage, die Wafer von Hand zu vereinzeln.

Bei einer aus der DE 199 04 834 A1 bekannten Einrichtung der eingangs genannten Art ist der Wafer-Stapel auf einem Tragarm eines Hubwerks in Flüssigkeit getaucht gehalten, wobei die einzelnen Silizium-Wafer horizontal angeordnet noch an einer Trägerglasplatte geklebt sind. Der jeweils oberste Silizium-Wafer wird mit Hilfe eines Werkzeugs von der Glasplatte abgelöst und mittels eines als Fördervorrichtung dienenden Flüssigkeitsstroms zu einer Kassette gefördert. Das notwendige Abtrennen jedes einzelnen Silizium-Wafers von der Trägerglasplatte benötigt Zeit und bringt die Gefahr einer Beschädigung der Kante des betreffenden Silizium-Wafers mit sich. Außerdem ist das Erfassen des abgelösten Silizium-Wafers vom Flüssigkeitsstrom mit Problemen behaftet, weil die einzelnen Silizium-Wafer aus ihrer horizontalen Lage um die Klebeverbindung mit der Trägerglasplatte abkippen können, so dass sie außenrandseitig am nachfolgenden unteren Silizium-Wafer haften können. Dieses Problem wird um so größer je großformatiger die Silizium-Wafer sind.

Aus der EP 0 414 157 A2 ist eine Einrichtung zum Vereinzeln von Kartons von einem Stapel bekannt, wobei die Kartons durch erste Rollen vom Stapel vereinzelt und durch ein zweites Rollenpaar herausgezogen werden. Diese vereinzelten Kartonstücke werden einer Vorrichtung zum Bedrucken, Schneiden, Perforieren, Falten oder dergleichen zugeführt. Dabei erfolgt die Vereinzelung der Kartonstücke dahingehend, dass die Geschwindigkeit der ersten Rollen jeweils von Null auf eine bestimmte kontante Geschwindigkeit hochgefahren und dann wieder auf Null zurückgefahren wird, sobald das Kartonstück von einem zweiten Rollenpaar erfasst wird, von dem das Kartonstück dann mit stetiger Geschwindigkeit der Vorrichtung zum Bedrucken etc. zugeführt wird.

Auch die US 2005/0 056 991 A1 zeigt eine Einrichtung zum Vereinzeln von gewellten Kartonstücken.

Ferner zeigt die DE 24 42 542 A1 eine Einrichtung zum Vereinzeln von Lochkarte.

Aufgabe der vorliegenden Erfindung ist es deshalb, eine Einrichtung zu schaffen, die die feuchten, im Stapel gehaltenen dünnen und bruchempfindlichen Wafer, auch großformatig, sicher und schnell voneinander trennt und vereinzelt.

Zur Lösung dieser Aufgabe sind bei einer Einrichtung zum Vereinzeln von feuchten Silizium-Wafern von einem Wafer-Stapel der genannten Art die in Anspruch 1 angegebenen Merkmale vorgesehen.

Durch die erfindungsgemäßen Maßnahmen ist erreicht, dass die einzelnen bereits von der Trägerglasplatte abgelösten und auf einem Wafer-Stapel flächig aufeinander liegenden feuchten Silizium-Wafer in einfacher und schneller Weise jeweils von der Unterseite des Stapels aus diesem herausgezogen werden können. Eine Beschädigung der Wafer an ihren Rändern ist dadurch vermieden. Diese Art des Entnehmens eines Silizium-Wafers aus einem Wafer-Stapel ist unabhängig vom Format der Wafer. Dabei ist auch erreicht, dass eine sichere Weiterbeförderung gewährleistet ist und ein zur weiteren Verarbeitung erwünschter Abstand zwischen den vereinzelten Wafern entsteht.

Mit den Merkmalen nach Anspruch 32 ist erreicht, dass im Nutenbereich der Vereinzelungswalzen der notwendige Flüssigkeitsfilm erhalten bleibt und überschüssige Feuchtigkeit abfließen kann.

Mit den Merkmalen nach Anspruch 3 und/oder 4 ist erreicht, dass die Walzenabstände enger gehalten werden können, um die dünnen bruchempfindlichen Wafer noch mehr abstützen zu können.

Mit den Merkmalen nach Anspruch 5 und/oder 6 ist erreicht, dass durch Konstanthalten der Auflagekraft gegen die elastischen Vereinzelungswalzen trotz abnehmendem Wafer-Stapel auch der Spalt zwischen der Abstreifleiste und der nachgiebigen Walzen-Ebene konstant, das heißt auf Waferdicke gehalten werden kann.

Weitere Einzelheiten der Erfindung sind der folgenden Beschreibung zu entnehmen, in der die Erfindung anhand des in der Zeichnung dargestellten Ausführungsbeispiels näher beschrieben und erläutert ist. Es zeigen:
- Figur 1: in schematischer Vorderansicht den auf Vereinzelungswalzen ruhenden Wafer-Stapel, der von einem Stempel angedrückt wird, mit der Abstreifleiste, dem Auszugswalzenpaar, zwischen dem sich gerade ein halb herausgezogener Wafer befindet, und den sich anschließenden Förderelementen und
- Figur 2: in schematischer Draufsicht die ineinander greifenden, gestuften Walzen mit der Lage des Wafer-Stapels, den verstellbaren seitlichen Führungsleisten, vor und nach der Vereinzelung sowie die Abstreifleiste und die obere Auszugswalze.

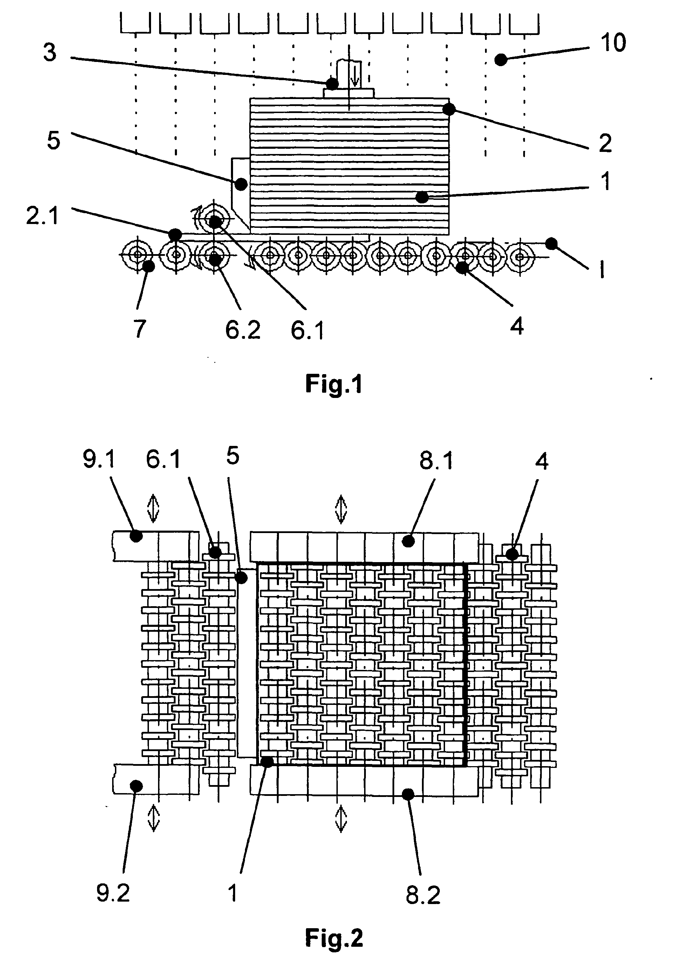

In Figur 1 erkennt man einen aus Silizium-Wafern 2 bestehenden Wafer-Stapel 1, der dadurch entstanden ist, dass ein Siliziumblock, der über eine Klebeverbindung an einer Trägerglasplatte haftet, durch Drahtsägen in eine Vielzahl von Silizium-Wafer 2 geschnitten wurde, und die Silizium-Wafer 2 nach dem Drahtsägen an der Verbindungs- bzw. Klebenaht vom Grund der Trägerglasplatte abgetrennt bzw. abgelöst wurden. Der Wafer-Stapel 1 aus den flächig aufeinanderliegenden feuchten Silizium-Wafern 2 ist auf Vereinzelungswalzen 4 aufgesetzt, die sich während des Abstapelns ständig drehen. Über eine Berieselungsanlage 10 werden die Wafer 2 zum Erleichtern des Abstapelns und für den sich anschließenden Prozess ständig feucht gehalten. Ein Stempel 3 mit geregelter Anpresskraft hält die Auflagekraft auf die außen umfangsseitig elastischen und damit nachgiebigen Vereinzelungswalzen unabhängig von der Waferstapelhöhe konstant. Damit wird erreicht, dass der Spalt zwischen der Vereinzelungswalzen-Ebene 1 und der Abstreifleiste 5 konstant auf geringfügig mehr als die Waferdicke gehalten wird, so dass nur ein dünner Wafer 2 hindurch geschoben beziehungsweise gezogen werden kann und der Rest des Stapels 1 zurückgehalten wird.

Sobald die Vereinzelungswalzen 4 aufgrund Reibschluss den untersten Wafer 2.1 ein stück ausgeschoben haben, wird der Vereinzelungsvorgang von Auszugswalzen 6.1 und 6.2 die als Paar übereinanderliegen, unterstützt. Die Auszugswalzen 6.1, 6.2 sind mit gleicher Drehzahl angetrieben und üben eine elastische Pressung auf den betreffenden Silizium-Wafer 2.1 aus, wobei ebenfalls eine reibschlüssige Verbindung zwischen den Auszugswalzen 6.1, 6.2 und dem Silizium-Wafer 2.1 entsteht. Die elastische Pressung wird beispielsweise durch eine federnd vorgespannte Lagerung der oberen Auszugswalze 6.1 erreicht. Die Auszugswalzen 6.1, 6.2 übergeben dann den Wafer 2.1 an sich anschließende Förderelemente 7, die sowohl als Walzen- oder Röllchenbahn, als Förderriemen oder Förderbänder oder in anderer geeigneter Weise ausgebildet sein können.

In Figur 2 ist insbesondere das Ineinandergreifen der durch aneinander gereihten vorzugsweise rechteckigen Nuten und Stegen gebildeten gestuften Walzen 4, 6.1 und 6.2 sowie gegebenenfalls 7 mit der Position des Wafer-Stapels 1 dargestellt. Die Einrichtung wird durch Führungsleisten 8.1, 8.2 und 9.1, 9.2 ergänzt und mit denen waferformatabhängig der Wafer-Stapel 1 seitlich positioniert und die vereinzelten Silizium-Wafer 2 geführt werden.

## Patentansprüche

1. Einrichtung zum Vereinzeln von feuchten Silizium-Wafern (2) von einem Wafer-Stapel (1), wobei die feuchten Wafer (2) einzeln vom Stapel (1) entnehmbar sind, mit einer Abstreifleiste (5) und einem übereinanderliegenden, mit gleicher Drehzahl angetriebenen Auszugswalzenpaar (6.1 und 6.2) und mit Vereinzelungswalzen (4), auf denen der Wafer-Stapel (1) aufsetzbar ist und durch deren Drehung der unterste Wafer (2.1) unter der Abstreifleiste (5) durch eine waferdicke Lücke zwischen Walzebene (1) und Abstreifleiste (5) schiebbar und durch elastische Pressung von dem Auszugswalzenpaar (6.1 und 6.2), aus dem Wafer-Stapel (1) herausziehbar ist, **gekennzeichnet durch** einen sich an die Vereinzelungswalzen (4) anschließende Fördervorrichtung (7), an die die einzelnen feuchten Wafer übergebbar sind, wobei die Fördervorrichtung **durch** ein oder mehrere Förderelemente (7) gebildet ist, die sich an die Vereinzelungswalzen (4) anschließen und eine höhere Fördergeschwindigkeit als die Vereinzelungswalzen (4) aufweisen.

2. Einrichtung nach Anspruch 1, **dadurch gekennzeichnet, dass** die Walzen (4; 6.1, 6.2; 7) mit rechteckigen Nuten zwischen rechteckigen Stegen versehen sind.

3. Einrichtung nach Anspruch 2, **dadurch gekennzeichnet, dass** die Nuten und Stege von Walze (4; 6.1, 6.2; 7) zu Walze (4; 6.1, 6.2; 7) jeweils zueinander um eine Teilung versetzt sind.

4. Einrichtung nach Anspruch 2 oder 3, **dadurch gekennzeichnet, dass** die Nuten und Stege benachbarter Walzen (4; 6.1, 6.2; 7) ineinander greifen.

5. Einrichtung nach mindestens einem der vorhergehenden Ansprüche, **dadurch gekennzeichnet dass** der Wafer-Stapel (1) mit einem Stempel (3) der Einrichtung gegen die Vereinzelungswalzen (4) anpressbar ist.

6. Einrichtung nach Anspruch 5, **dadurch gekennzeichnet, dass** die Anpresskraft des Stempels (3) so regelbar ist, dass die Summe aus Gewicht des Stapels (1) und der Anpresskraft mit abnehmender Höhe des Stapels (1) konstant gehalten ist.

## Claims

1. A device for separating wet silicon wafers (2) from a wafer stack (1), wherein the wet wafers (2) can be individually removed from the stack (1), including a stripping bar (5) and a superimposed extracting roller pair (6.1 and 6.2) driven with the same rotational speed, and including separating rollers (4), on which the wafer stack (1) can be placed, and by the rotation of which the lowest wafer (2.1) can be pushed below the stripping bar (5) through a wafer-thick gap between roller plane (1) and stripping bar (5), and can be extracted from the wafer stack (1) by elastic compression from the extracting roller pair (6.1 and 6.2), **characterized by** a conveyor (7) adjoining the separating rollers (4), to which the individual wet wavers can be passed, wherein the conveyor is constituted by one or more conveying elements (7) adjoining the separating rollers (4) and having a higher conveying velocity than the separating rollers (4).

2. The device according to claim 1, **characterized in that** the rollers (4; 6.1, 6.2; 7) are provided with rectangular grooves between rectangular ridges.

3. The device according to claim 2, **characterized in that** the grooves and ridges are each offset to each other by a pitch from roller (4; 6.1, 6.2; 7) to roller (4; 6.1, 6.2; 7).

4. The device according to claim 2 or 3, **characterized in that** the grooves and ridges of adjacent rollers (4; 6.1, 6.2; 7) engage with each other.

5. The device according to at least one of the preceding claims, **characterized in that** the wafer stack (1) can be pressed against the separating rollers (4) with a stamp (3) of the device.

6. The device according to claim 5, **characterized in that** the contact pressing force of the stamp (3) is controllable such that the sum of weight of the stack (1) and contact pressing force is kept constant with decreasing height of the stack (1).

## Revendications

1. Dispositif destiné à séparer des tranches de silicium humides (2) d'une pile de tranches (1), les tranches humides (2) pouvant être retirées de la pile (1) une par une au moyen d'une bande racleuse (5) et d'une paire de cylindres d'extraction (6.1 et 6.2) superposés entraînés à la même vitesse de rotation et au moyen de cylindres de séparation (4) sur lesquels la pile de tranches (1) peut être posée, et la rotation desdits cylindres permettant de pousser la tranche inférieure (2.1) sous la bande racleuse (5) à travers une fente de l'épaisseur de la tranche entre le plan (1) des cylindres et la bande racleuse (5), ladite tranche pouvant être extraite de la pile de tranches (1) par une pression élastique exercée par la paire de cylindres d'extraction (6.1 et 6.2), **caractérisé par** un dispositif de transport (7) disposé à côté des rouleaux de séparation (4) et sur lequel les tranches humides individuelles peuvent être transférées, le dispositif de transport étant formé par un ou plusieurs éléments de transport (7) disposés à côté des cylindres de séparation (4) et présentant une vitesse de transport supérieure à celle des cylindres de séparation (4).

2. Dispositif selon la revendication 1, **caractérisé en ce que** les cylindres (4 ; 6.1, 6.2 ; 7) sont pourvus de rainures rectangulaires entre des nervures rectangulaires.

3. Dispositif selon la revendication 2, **caractérisé en ce que** les rainures et les nervures d'un cylindre (4 ; 6.1, 6.2 ; 7) sont décalées respectivement les unes des autres d'une séparation.

4. Dispositif selon la revendication 2 ou 3, **caractérisé en ce que** les rainures et les nervures de cylindres (4 ; 6.1, 6.2 ; 7) voisins s'insèrent les unes dans les autres.

5. Dispositif selon au moins l'une des revendications précédentes, **caractérisé en ce que** la pile de tranches (1) peut être pressée au moyen d'un poinçon (3) du dispositif contre les cylindres de séparation (4).

6. Dispositif selon la revendication 5, **caractérisé en ce que** la pression appliquée par le poinçon (3) peut être réglée de sorte que la somme du poids de la pile (1) et de la pression appliquée soit maintenue constante à mesure que la hauteur de la pile (1) diminue.
